(19)

Europäisches
Patentamt
European
Patent Office
Office européen
des brevets

(11) **EP 3 851 915 A1**

(12) **EUROPEAN PATENT APPLICATION**

(43) Date of publication:
**21.07.2021 Bulletin 2021/29**

(51) Int Cl.:
**G03F 7/20** $^{(2006.01)}$

(21) Application number: **20151585.5**

(22) Date of filing: **14.01.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
**KH MA MD TN**

(71) Applicant: **ASML Netherlands B.V.**
**5500 AH Veldhoven (NL)**

(72) Inventors:
• **NIENHUYS, Han-Kwang**
**5500 AH Veldhoven (NL)**
• **COENEN, Teis Johan**
**5500 AH Veldhoven (NL)**
• **ROOBOL, Sander Bas**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR CORRECTING MEASUREMENTS IN THE MANUFACTURE OF INTEGRATED CIRCUITS AND ASSOCIATED APPARATUSES**

(57)   Disclosed is a method of metrology. The method comprises obtaining measurement data relating to at least one measurement of each of one or more structures on a substrate. The measurement data is dependent upon one or more drift parameters, said drift parameters comprising at least one interdependent drift parameter for which each measurement is dependent on a structure response metric which varies with an illumination setting and said at least one interdependent drift parameter interdependently. The measurement data is corrected based on an approximately invariant transformation of said structure response metric or related metric.

Fig.11

**Description**

FIELD

The present invention relates to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-IR wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology (i.e. moving towards the "soft X-ray (SXR)" wavelength spectrum), it is possible to resolve smaller structures, to increase sensitivity to structural variations of the structures and/or penetrate further into the product structures. One such method of generating suitably high frequency radiation (e.g., soft X-ray and/or EUV radiation) may be using a pump radiation (e.g., infra-red radiation) to excite a generating medium, thereby generating an emitted radiation, optionally a high harmonic generation comprising high frequency radiation.

It is desirable to eliminate or mitigate the signal impact due to drift parameter variation, i.e., parameters which are subject to drift from assumed, nominal and/or designed values. Such drift parameters may comprise, for example, detector position, illumination polar angles (incident angle and azimuth angle) and layer thickness of one or more substrate layers.

SUMMARY

In a first aspect of the invention there is provided a method of metrology comprising: obtaining measurement data relating to at least one measurement of each of one or more structures on a substrate; the measurement data being dependent upon one or more drift parameters, said drift parameters comprising at least one interdependent drift parameter for which each measurement is dependent on a structure response metric which varies with an illumination setting and said at least one interdependent drift parameter interdependently; and correcting the measurement data based on an approximately invariant transformation of said structure response metric or related metric.

Also disclosed is a computer program, metrology apparatus and a lithographic apparatus being operable to perform the method of the first aspect.

The above and other aspects of the invention will be understood from a consideration of the examples described below.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 depicts a schematic representation of a metrology apparatus in which EUV and/or SXR radiation is used;
- Figure 6 depicts a simplified schematic drawing of an illumination source, which may be the illumination source for high harmonic generation for a metrology apparatus such as that illustrated in Figure 5;
- Figure 7 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 8 depicts a schematic overview of a level sensor apparatus which may use methods according to embodiments of the invention;
- Figure 9 depicts a schematic overview of an alignment sensor apparatus which may use methods according to embodiments of the invention;
- Figure 10 is a flowchart describing a method according to embodiments of the invention;
- Figure 11 is a reflectivity plot showing variation in a reflectivity metric from a target with illumination angle $\theta$ (y-axis) and wavelength $\lambda$ (x-axis); and
- Figure 12 shows (a) a plot of intensity in pupil space (planar diffraction) with and without displaced illumination and (b) a difference between nominal and displaced signal in terms of the geometric contribution and contribution due to target response.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

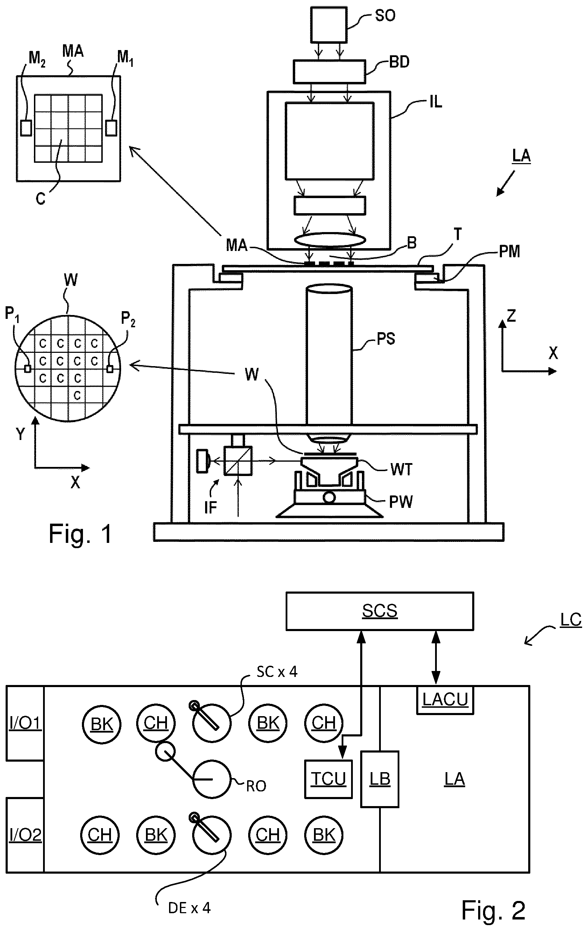

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray, extreme ultraviolet (EUV) and visible to near-IR wavelength range.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

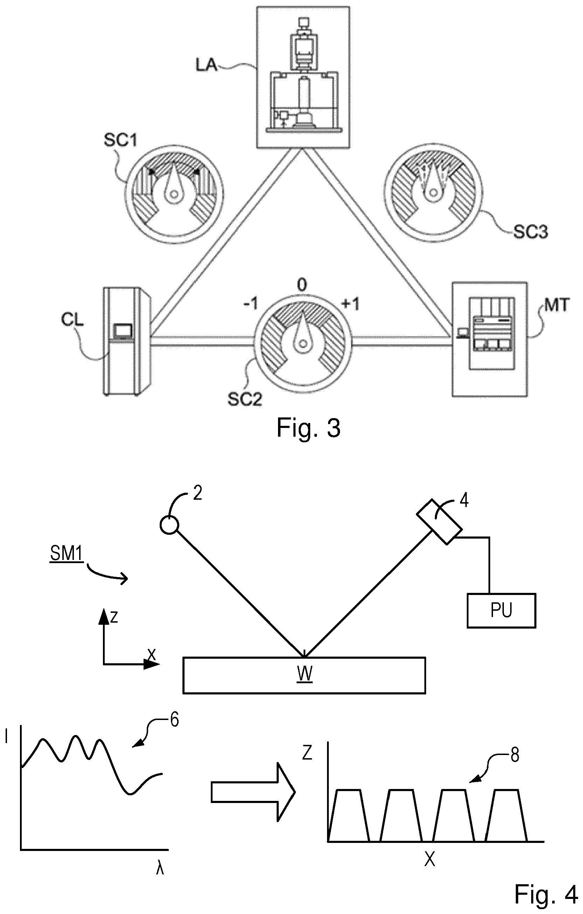

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray, extreme ultraviolet and visible to near-IR wave range.

A metrology apparatus, such as a scatterometer, is depicted in figure 4. It comprises a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

As an alternative to optical metrology methods, it has also been considered to use soft X-rays or EUV radiation (may be referred as SXR in the following text), for example radiation in a wavelength range between 0.1nm and 100nm, or optionally between 1nm and 50 nm or optionally between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. Reflectometry techniques using X-rays (GI-XRS) and extreme ultraviolet (EUV) radiation at grazing incidence are known for measuring properties of films and stacks of layers on a substrate. Within the general field of reflectometry, goniometric and/or spectroscopic techniques can be applied. In goniometry, the variation of a reflected beam with different incidence angles is measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in the soft X-rays or EUV domain not sufficient. Therefore published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The content of the cited US patent application are incorporated herein by reference in their entirety.

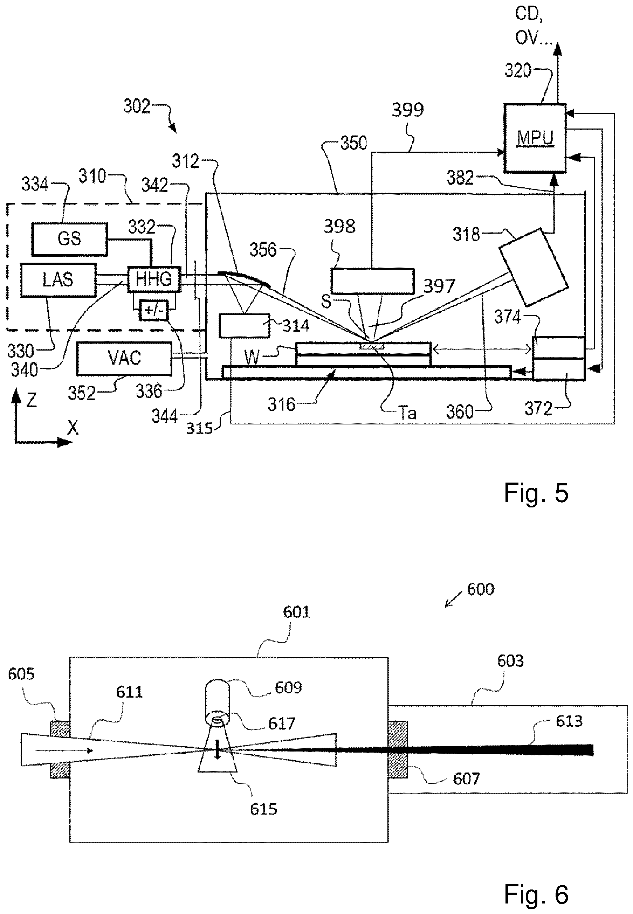

Figure 5 depicts a schematic representation of a metrology apparatus 302 in which radiation in the wavelength range from 0.1 nm to 100 nm may be used to measure parameters of structures on a substrate. The metrology apparatus 302 presented in Figure 5 is suitable for the soft X-rays or EUV domain.

Figure 5 illustrates a schematic physical arrangement of a metrology apparatus 302 comprising a spectroscopic scatterometer using EUV and/or SXR radiation in grazing incidence, purely by way of example. An alternative form of inspection apparatus might be provided in the form of an angle-resolved scatterometer, which uses radiation in normal or near-normal incidence similar to the conventional scatterometers operating at longer wavelengths.

Inspection apparatus 302 comprises a radiation source 310, illumination system 312, substrate support 316, detection systems 318, 398 and metrology processing unit (MPU) 320.

Source 310 in this example comprises a generator of EUV or soft x-ray radiation based on high harmonic generation (HHG) techniques. Main components of the radiation source are a drive laser 330 and an HHG gas cell 332. A gas supply 334 supplies suitable gas to the gas cell, where it is optionally ionized by an electric source 336. The drive laser 300 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be for example in the region of 1 $\mu$m (1 micron). The laser pulses are delivered as a first radiation beam 340 to the HHG gas cell 332, where in the gas a portion of the radiation is converted to higher frequencies than the first radiation into a beam 342 including coherent second radiation of the desired wavelength or wavelengths.

The second radiation may contain multiple wavelengths. If the radiation were monochromatic, then measurement calculations (for example reconstruction) may be simplified, but it is easier with HHG to produce radiation with several wavelengths. The volume of gas within the gas cell 332 defines an HHG space, although the space need not be completely enclosed and a flow of gas may be used instead of a static volume. The gas may be for example a noble gas such as neon (Ne) or argon (Ar). N2, O2, He, Ar, Kr, Xe gases can all be considered. These may be selectable options within the same apparatus. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific harmonic wavelengths from among those generated in the gas cell. Some or all of the beam path may be contained within a vacuum environment, bearing in mind that SXR radiation is absorbed when traveling in air. The various components of radiation source 310 and illumination optics 312 can be adjustable to implement different metrology 'recipes' within the same apparatus. For example different wavelengths and/or polarization can be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 1-20 nm or optionally in the range 1-10 nm or optionally in the range 10-20 nm may be chosen. Wavelengths shorter than 5 nm suffer from very low critical angle when reflecting off materials typically of interest in semiconductor manufacture. Therefore to choose a wavelength greater than 5 nm will provide stronger signals at higher angles of incidence. On the other hand, if the inspection task is for detecting the presence of a certain material, for example to detect contamination, then wavelengths up to 50 nm could be useful.

From the radiation source 310, the filtered beam 342 enters an inspection chamber 350 where the substrate W including a structure of interest is held for inspection at a measurement position by substrate support 316. The structure of interest is labeled T. The atmosphere within inspection chamber 350 is maintained near vacuum by vacuum pump 352, so that EUV radiation can pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 μm in diameter, when projected onto the structure of interest. Substrate support 316 comprises for example an X-Y translation stage and a rotation stage, by which any part of the substrate W can be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 310 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a soft X-ray and/or EUV spectroscopic reflectometer of the kind described in US2016282282A1 which content is incorporated herein by reference in its entirety.

If the target T has a certain periodicity, the radiation of the focused beam 356 may be partially diffracted as well. The diffracted radiation 397 follows another path at well-defined angles with respect to the angle of incidence then the reflected radiation 360. In Figure 5, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 5 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 can also communicate with a position controller 372 which operates the translation stage, rotation and/or tilting stages. Processor 320 receives highly accurate feedback on the position and orientation of the substrate, via sensors. Sensors 374 may include interferometers, for example, which can give accuracy in the region of picometers. In the operation of the inspection apparatus 302, spectrum data 382 captured by detection system 318 is delivered to metrology processing unit 320.

As mentioned an alternative form of inspection apparatus uses soft X-ray and/or EUV radiation at normal incidence or near-normal incidence, for example to perform diffraction-based measurements of asymmetry. Both types of inspection apparatus could be provided in a hybrid metrology system. Performance parameters to be measured can include overlay (OVL), critical dimension (CD), focus of the lithography apparatus while the lithography apparatus printed the target structure, coherent diffraction imaging (CDI) and at-resolution overlay (ARO) metrology. The soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 can be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) to obtain radiation at the desired wavelength(s). One of the challenges faced in the development of these sources is how to couple the emitted radiation out of the generating setup efficiently and separate the emitted radiation from the radiation used to drive the process.

Figure 6 shows a simplified schematic drawing of an embodiment 600 of an illumination source 310, which may be the illumination source for high harmonic generation. One or more of the features of the illumination source in the metrology tool described with respect to Figures 5 may also be present in the illumination source 600 as appropriate. The illumination source 600 comprises a chamber 601. The illumination source 600 is configured to receive a pump radiation 611 with a propagation direction which is indicated by an arrow. The pump radiation 611 shown here is an example of the pump radiation 340 from the pump radiation source 330, as shown in Figure 5. The pump radiation 611 may be directed into the chamber 601 through the radiation input 605, which maybe a viewport which may be made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume (for example several cubic mm) of a particular gas (e.g., a noble gas, optionally Helium, Argon, or Neon, nitrogen, oxygen or carbon dioxide) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). Optionally, the gas flow 615 is provided by the gas delivery system into an evacuated or nearly evacuated space. The gas delivery system comprises a gas nozzle 609, as shown in Figure 6, which comprises an opening 617 in an exit plane of the gas nozzle 609. The gas flow 615 is provided from the opening 617. In almost all the prior arts, the gas nozzle has a cut tube geometry shape which is a uniform cylinder interior geometry shape, and the shape of the opening in the exit plane is round. An elongated opening has also been used as described in the patent application CN101515105B.

The dimensions of the gas nozzle 609 may conceivably also be used in scaled-up or scaled-down versions ranging from micrometer-sized nozzles to meter-sized nozzles. This wide range of dimensioning comes from the fact that the setup should be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 5. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation outlet 607, e.g. an aperture or window, and may be subsequently manipulated and directed by an illumination system 603, which may be an example of the illumination system 312 in Figure 5, to a wafer to be inspected for metrology measurements. The emitted radiation 613 may be guided, optionally focused, to a target on the wafer.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation outlet 607 and entering the illumination system 603. This may be done by incorporating a filtering device 344 shown in Figure 5 into the radiation outlet 607, which is placed in the emitted beam path and that is opaque or nearly opaque to the driving radiation (e.g. opaque or nearly opaque to infrared or visible light) but at least partially transparent to the emitted radiation beam. The filter may be manufactured using zirconium. The filter may be a hollow, optionally an annular, block when the pump radiation 611 has a hollow, optionally an annular, transversal cross-sectional profile.

Described herein are methods, apparatuses, and assemblies to obtain emitted radiation optionally at a high harmonic frequency of pump radiation. The radiation generated through the process, optionally the HHG which uses non-linear effects to generate radiation at a harmonic frequency of provided pump radiation, may be provided as radiation in metrology tools MT for inspection and/or measurement of substrates. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. Throughout the description and claims, "radiation comprising one or more wavelengths" may describe, for example, radiation having a spectrum comprising energy or power in one or more wavelength ranges; e.g., the illumination radiation may have substantial energy (e.g., above a nominal threshold) in a specific wavelength range). The pump radiation may comprise infrared radiation. The pump radiation may comprise radiation with wavelength(s) (e.g., substantial energy) in the range of 700 nm to 1500 nm. The pump radiation may comprise radiation with wavelength(s) in the range of 900 nm to 1300 nm. The pump radiation may comprise radiation with wavelength(s) in the range of 100 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet (EUV), soft X-Ray (SXR), and/or hard X-Ray part of the electromagnetic spectrum. The emitted radiation 613 may comprise wavelengths in the range of 0.01 nm to 100 nm. The emitted radiation 613 may comprise wavelengths in the range of 0.1 nm to 100 nm. The emitted radiation 613 may comprise wavelengths in the range of 0.1 nm to 50 nm. The emitted radiation 613 may comprise wavelengths in the range of 1 nm to 50 nm. The emitted radiation 613 may comprise wavelengths in the range of 10 nm to 20 nm.

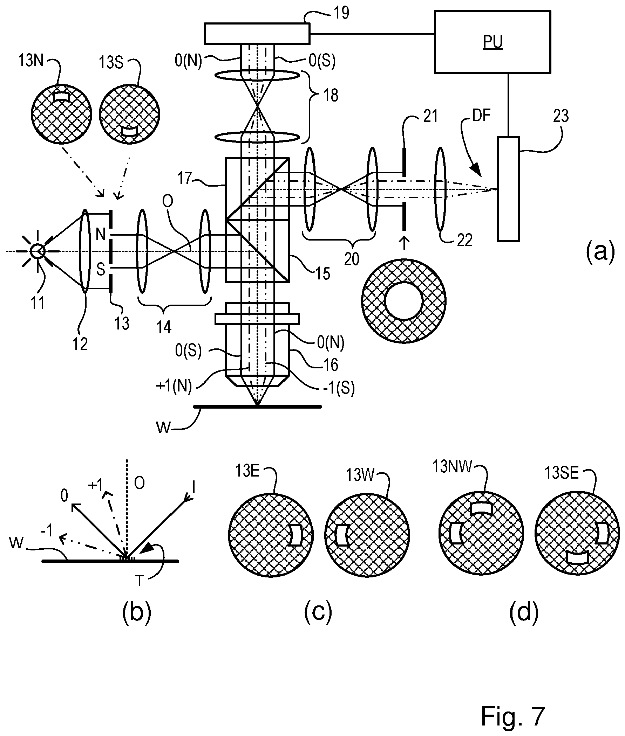

A further metrology apparatus suitable for use in embodiments of the invention is shown in Figure 7(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 7(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 7(b), target structure T is placed with substrate W normal to the optical axis O of objective lens 16. The substrate W may be supported by a support (not shown). A ray of measurement radiation I (e.g., comprising SXR wavelengths) impinging on target structure T from an angle off the axis O gives rise to a zeroth order ray (solid line 0) and two first order rays (dot-chain line +1 and double dot-chain line -1). It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 7(a) and 7(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 7(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 7(c) and (d). The use of these, and numerous other variations and applications of the apparatus are described in prior published applications, mentioned above.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

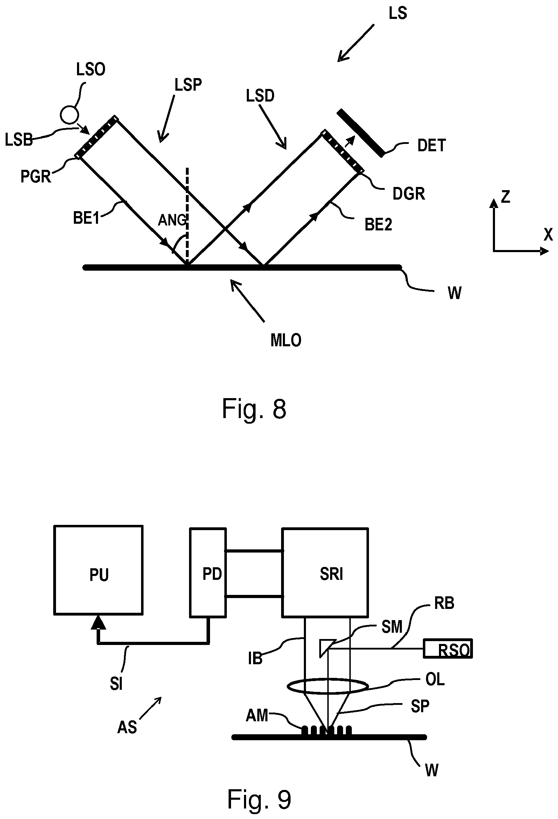

An example of a level or height sensor LS as known in the art is schematically shown in Figure 8, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass SXR wavelengths, UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 9 is a schematic block diagram of an embodiment of a known alignment sensor AS, such as is described, for example, in US6961116, and which is incorporated by reference. Radiation source RSO provides a beam RB of radiation of one or more wavelengths (e.g., comprising SXR wavelengths), which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

In SXR metrology, a target (or more generally a structure e.g., a periodic pattern on a wafer) is illuminated with a soft X-ray beam (which may have, for example, a divergence 2 mrad, and bandwidth 9 nm-20 nm). The diffraction pattern is captured by one or more image sensors; for example, in some arrangements there may be three separate sensors, respectively for the positive diffraction orders, the zeroth (specular) order and the negative diffraction orders. Each wavelength component in the SXR beam may create diffraction spots in a different location on a respective sensor.

The diffraction pattern (intensity as a function of position on the detector) is the combined effect of three categories of parameters:

1) Target parameters; these include (a) parameters of interest such as overlay (OVL) and critical dimension (CD)- the target is designed for measuring and monitoring of these parameters; and (b) nuisance parameters which affect the measurement but are not necessarily of interest. Examples include the refractive index of the material (e.g., $SiO_2$); sidewall angle of a buried structure created in an earlier etching step and (in some situations), the thickness $h$ of a layer or combination of layers at or near the top of the stack.

2) Properties of the incident SXR beam: e.g., power, spectrum, divergence, and polarization;

3) The metrology-tool alignment: angle of incidence $\theta$ and azimuthal angle $\varphi$ of the incident beam relative to the wafer and detector position and orientation (e.g., in 6 degrees of freedom DoF) relative to the target (point where the chief ray of the incident beam is incident on the wafer). In total, there may be 8 DoF in tool alignment. Note that a position or orientation error of the target itself will also contribute to these 8 DoF. It is assumed, where there are multiple image sensors, they do not move relative to each other; otherwise there would be additional degrees of freedom.

In a SXR metrology tool, the goal is to estimate target parameters of interest from a measured diffraction pattern (category 1(a)). It is generally necessary or at least desirable to eliminate or mitigate the signal impact due to drift parameter variation, i.e., parameters in category 1(b), 2 and 3 which are subject to drift from expected, assumed, nominal and/or designed values (where drift can be defined as the difference between an actual value of a parameter and its expected, assumed, nominal and/or designed value). One approach is to design a metrology tool with sufficient stability and reproducibility that the variation (from minute to minute or month to month) for some of these parameters is negligible. Such an approach is not feasible in practice; the stability requirements would be very expensive to meet and such an approach will not help with those drift parameters in category 1(b) in any case. Another approach is to measure the tool parameters and take them into account in the analysis. This may be feasible for the beam parameters (category 2), since most beam properties will be measured simultaneously with the measurements on targets. However, monitoring of the other drift parameters is either not possible or impractical in terms of the constraints imposed by a high-volume IC manufacturing processes.

It is desirable to provide a method which can eliminate or mitigate the influence of one or more such drift parameter errors from a measurement on a target, without prior knowledge on how the specific target responds to changes in the alignment parameters.

In particular, it is desirable to provide a method which can eliminate or mitigate the influence of "entangled" or interdependent drift parameters, e.g., drift parameters for which the target response and tool alignment are interdependent; e.g., there is crosstalk between these parameters. Examples of two such interdependent drift parameters include angle of incidence $\theta$ and wafer/stack thickness $h$. For example, the consequence of variation in the angle of incidence $\theta$ is not only a shift of the diffraction pattern on the detector, but also a change in a target response metric (or structure response metric) such as the target diffraction coefficient(s); e.g., the fraction of incident power that is diffracted to a given diffraction order, for a given wavelength and/or polarization. To illustrate this by way of a specific numerical example: the 14.00 nm wavelength component of the incident beam for a particular target may be diffracted into the first order for $\theta$ = 35.00 deg but not diffracted at $\theta$ = 35.01 deg or *vice versa.*

An embodiment comprises performing data processing steps on a set of measurements relating to the same type of target. Differences between these measurements may result from a number of aspects including, for example: tool drift, tool-to-tool variations, and small difference in target parameters (e.g., OVL, CD). These measurements may be described by a 3D array $I[i,j,k]$, where $i$ refers to an individual measurement in the set and j and k refer to detector pixel rows and columns, respectively. These measurements may optionally have undergone minor pre-processing, such as for noise removal.

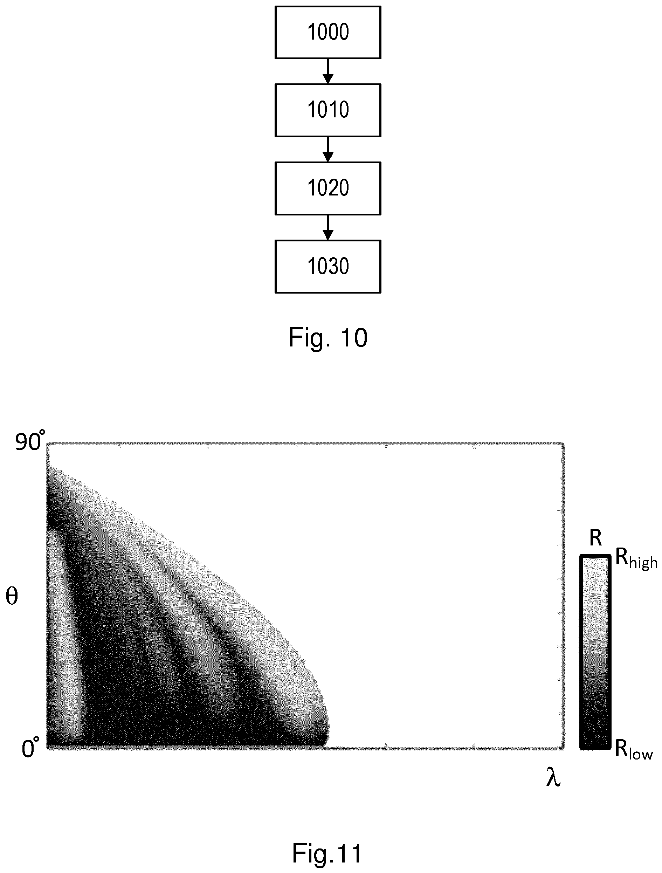

Figure 10 is a flowchart describing such a method according to an embodiment. Not that the following paragraphs describe only one possible embodiment. It describes one example of a specific implementation which takes advantage of the interdependence between specific drift parameters (e.g., angle of incidence $\theta$, stack thickness $h$ and wavelength $\lambda$). Furthermore the mathematical details are described only for one particular example geometrical layout, for illustration.

At step 1000 a difference $\Delta I[i,j,k]$ between each measurement image $I[i,j,k]$ and a reference image $I_0[j,k]$ is calculated; e.g., $\Delta I[i,j,k] = I[i,j,k] - I_0[j,k]$. The reference image $I_0[j,k]$ may be a single image, and may comprise an average of the measurement set $I[i,j,k]$ or DC signal. As such, the DC signal $I_0[j,k]$ describes a non-varying component of the measurement images $I[i,j,k]$ and the difference intensity measurements $\Delta I[i,j,k]$ describes a varying component of the measurement images $I[i,j,k]$.

At step 1010, partial derivatives $J[i,j,k,m]$ related to drift parameters are estimated for each dataset (each value of $i$). Here, $m$ refers to the drift parameter number. For example, $m$ can be in the range 1 to 9 to cover the 8 DoF of tool alignment and additionally a wafer parameter such as stack thickness. It could also include other tool parameters such as (e.g., SXR) illumination source power and/or beam divergence. The partial derivatives describe, for each drift parameter, how the measurement images (intensity distributions) change with drift in the drift parameters.

At step 1020, coefficients $c[i,m]$ are determined from a minimization of a suitable cost function (e.g., least-squares). A specific example may comprise e.g., :

$$\Delta \hat{I}[i,j,k] = \Delta I[i,j,k] - \sum_m c[i,m]\, J[i,j,k,m] \qquad (1)$$

In this manner, one or more components of the difference intensity measurements $\Delta I[i,j,k]$ attributable to drift in one or more of the drift parameters is subtracted from the intensity measurements $\Delta I[i,j,k]$ to obtain corrected measurements or drift-independent varying images $\Delta \hat{I}[i,j,k]$. As such, the drift-independent varying images are minimized in terms of the difference between the difference signals images and a linear combination of the partial derivatives. The least-squares minimization may optionally account for estimated noise levels in the pixels. Other figures of merit than 'sum of squared deviations' may also be used to find the coefficients. For example, Bayesian analysis, which accounts for a known or estimated probability distribution of the coefficients $c$, or a method which can handle non-Gaussian noise in the signal may be used.

In an alternative embodiment, rather than first pre-processing the data by removing a signal contribution attributable to the drift parameters and then interpreting the pre-processed data to infer information about parameters of interest, a parameter of interest may be fitted together with the drift parameters.

At step 1030, the drift independent varying images $\Delta \hat{I}$ may be used as the corrected measurement signals from which a parameter of interest (e.g., overlay, CD, focus) may be determined. Alternatively, or in addition the drift independent varying images $\Delta \hat{I}$ may be used in further analysis or reconstruction; for example, the set of original signals could comprise a number of reference measurements from targets with known overlay and from a set of targets with unknown overlay.

The data above is described in terms of rows and columns of pixels comprised within an image sensor signal; however, it can optionally be described in terms of a combined signal from multiple image sensors, or else a signal which is mapped into pupil space $(k_x,k_y)$ (see below).

More detail of how step 1010 may be performed will now be described. This describes estimating partial derivatives $J[i,j,k,m]$ to tool alignment/wafer drift parameters without information other than measurements $I[i,j,k]$ and an approximate estimate of the drift parameters; e.g., the nominal (designed) values of those tool parameters and/or wafer parameters. The method describes, in particular, methods for estimating these partial derivatives for the interdependent drift parameters for which the target response varies with illumination setting (e.g., where illumination setting may describe one or both of a wavelength and/or polarization of the illumination radiation) and the drift parameter(s) interdependently. In the treatment below, the index i will be dropped from the equations.

Estimating partial derivatives for two specific such interdependent parameters will be explicitly described, namely angle of incidence $\theta$ of the illumination beam on the substrate and the layer or stack thickness $h$. While these are both nominally set to a values (e.g., angle of incidence $\theta$ may be set to any nominal value between 10° - 70°, a set value for thickness $h$ will vary per application), control of these parameters cannot be perfect and as such there may be some deviation in the actual values around the set or expected values. The fact that a target response metric (e.g., such as the target reflectance as a function of wavelength and diffraction-order number) and therefore the measured intensity distributions is dependent on each of these parameters interdependently with wavelength means that determining the partial derivatives for these interdependent parameters is not straightforward. In addition, methods for determining partial derivatives for other tool alignment parameters will be described; these include the other illumination polar angle, azimuth angle $\varphi$, and detector position and orientation (6 DoF).

In the description below, the mapping, from a signal represented as a detector image $I[j,k]$ to the same signal represented in pupil space, $\hat{I}(\kappa)$ will be available, parametrized by one or more tool alignment/wafer parameters; e.g., up to 9 DoF (8 tool alignment DoFs and stack thickness $h$) with parameters $(p_1, ..., p_9)$. The parameter $\kappa$ represents the $(\kappa_x, \kappa_y)$ vector in pupil space, i.e., the x and y components of the direction unit vector $(\kappa_x, \kappa_y, \kappa_z)$ of a ray, with the target in the xy plane. The representation in pupil space may be continuous, rather than in terms of discrete pixels; this can be achieved using a suitable interpolation method. Also available will be the inverse mapping, i.e., from $\hat{I}$ to $I$.

The derivatives for the illumination angle $\theta$, as has already been stated is affected by both geometrical effects and target-response effects, in that diffraction efficiency or reflectance $R(\lambda, \theta)$ depends on both wavelength and angle of incidence. However, the inventors have appreciated that, upon closer inspection, the reflectance $R(\lambda, \theta)$ appears to be approximately invariant under the transformation:

$$(\lambda, \theta) \rightarrow \left( \lambda \frac{\cos \theta'}{\cos \theta}, \theta' \right) \qquad (2)$$

and therefore:

$$R(\lambda, \theta) \approx R\left( \lambda \frac{\cos \theta'}{\cos \theta}, \theta' \right) \qquad (3)$$

for $\theta$, $\theta'$ between 20 and 70 deg, where $\theta$, $\theta'$ are two different values of the angle of incidence. It is therefore proposed to determine the partial derivative for the drift parameter $\theta$ based on this transformation.

Figure 11 is a reflectance or diffraction efficiency plot of illumination angle $\theta$ against wavelength $\lambda$ which illustrates this. The reflectance/diffraction efficiency $R$ is described by the shading from low reflectance $R_{low}$ (dark) to high reflectance $R_{high}$ (light). This plot illustrates that, for a diffraction coefficient value $R$ there is a predictable set of $(\lambda, \theta)$ pairs forming the visible lines or ridges of seen in the shading of the plot. As such, for each $(\lambda, \theta)$ pair of a particular diffraction coefficient value $R$, it is possible to reconstruct in a predictable manner, other $(\lambda, \theta)$ pairs having the same diffraction coefficient value.

More specifically, this invariance can be understood in terms of interference between different layers of the target; with layer-to-layer distance $h$, the phase difference between reflections from the upper and lower layers is $4\pi h \cos(\theta)/\lambda$, which can be seen to be indeed invariant under the above transformation. This is valid at least at SXR wavelengths, where the refractive index is always close to 1.0.

Based on this and substituting $c = 2\cos\theta$, the reflection coefficient for diffraction order $n$ can be written as $R_n(\lambda, c)$, and has the partial derivative $\dfrac{\partial R_n}{\partial c}$ in terms of c (and therefore illumination angle $\theta$) which can be expressed as:

$$\frac{\partial R_n}{\partial c} = -\frac{-\lambda c'}{c^2}$$

$$\frac{\partial R_n}{\partial \lambda} = \frac{c'}{c}$$

$$\frac{\partial R_n}{\partial c} = -\frac{\lambda}{c}\frac{\partial R_n}{\partial \lambda} \qquad (4)$$

It is more convenient to define the reflection coefficient in pupil space. In order to keep the math clearer and more manageable, the example below will describe the situation for a 1D-periodic target with planar (not conical) diffraction. The more general case of diffraction from a 2D-periodic target can be calculated along the same lines, as will be readily apparent to the skilled person. Therefore:

$$R'_n(K, c) = R_n\left(\frac{pK}{n}, c\right) \qquad (5)$$

where $p$ is the target pitch and $K = n\lambda/p$ is the diffraction distance in pupil space, $K = \kappa - \kappa_0$, between the pupil position of the diffracted ray $\kappa$ and the pupil position of the specularly reflected ray $\kappa_0$.

Assuming a flat illumination spectrum, then the diffraction pattern in pupil space is:

$$\hat{I}(\kappa, \kappa_0) = S \sum_n R'_n\left(\kappa - \kappa_0, 2\sqrt{1 - \kappa_0^2}\right) \qquad (6)$$

based on $\cos\theta = (1 - \kappa_0^2)^{1/2}$ and where $S$ is a scaling for the illumination (SXR) power. Here, $\hat{I}$ is a function of two parameters. From this, it is possible to derive the expression by applying the chain rule; note that $n$ is eliminated. It can be appreciated that a measurement provides $\hat{I}(\kappa, \kappa_0)$ for a range of $\kappa$ values (the pupil space) and a single value of $k_0$ and that the nominal value is already known: $\kappa_0 = \sin\theta$. The partial derivative $\partial\hat{I}/\partial\kappa$ can be estimated from numerical differentiation:

$$\frac{\partial \hat{I}}{\partial \kappa_0} = -\frac{\partial \hat{I}}{\partial \kappa}\left[1 + \frac{(\kappa_0 - \kappa)\kappa_0}{1 - \kappa_0^2}\right] \qquad (7)$$

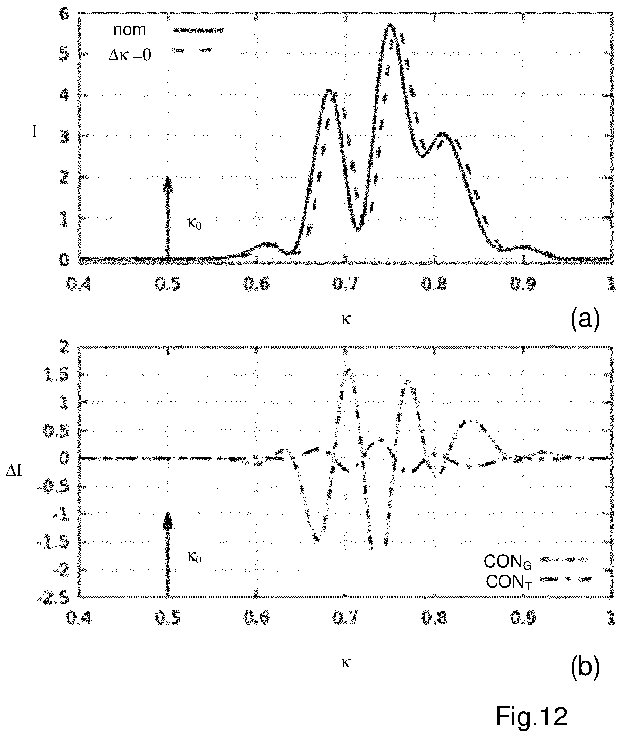

An example can be seen in Figure 12 which shows (a) an intensity plot in pupil space (planar diffraction) with and without displaced illumination ($\kappa_0$) and (b) the difference between nominal and displaced signal in terms of a contribution due to the geometrical effect $CONT_G$ and a contribution due to the target response to changes in the angle of incidence. Comparing this latter plot to Equation (7), it can be appreciated that the first term in the brackets is the contribution due to the geometrical effect and the second term is the contribution due to the target response to changes in the angle of incidence.

It can be appreciated that the quantity $c = 2\cos\theta$ may be replaced by $c = \cos\theta_0 + \cos\theta_d$, where $\theta_0$ is the angle with the normal of the specular reflection and $\theta_d$ is the angle with the normal of the diffracted ray.

The derivative in pupil space can be mapped back to a derivative in detector-pixel space.

The above treatment is based on an assumption of a smooth SXR illumination spectrum. In many cases this may be true, and even where this is not the case, e.g., if the SXR reflectance spectrum of the target is more 'spiky' than the illumination spectrum, it may still be reasonable approximation. Otherwise, the second term inside the brackets may include some data on the source spectrum to address particularly spiky or non-smooth SXR illumination spectra.

A further consequence of the underlying physical mechanism of the reflection spectrum being mostly a function of the expression $4\pi h \cos(\theta)/\lambda$ is that much of the above treatment described in terms of incidence angle $\theta$, can be adapted for the layer thickness $h$. This means that the reflectance spectrum as a function of layer thickness and wavelength is also invariant under the transformation:

$$(\lambda, h) \rightarrow \left( \lambda \frac{h'}{h}, h' \right) \qquad (8)$$

and therefore

$$R(\lambda, h) \approx \mathrm{R}\left( \lambda \frac{h'}{h}, h' \right) \qquad (9)$$

This can be used to construct a derivative of the target reflection spectrum $R(\lambda, h)$ with respect to the layer thickness:

$$\frac{\partial R}{\partial h} = -\frac{\lambda}{h} \frac{\partial R}{\partial \lambda} \qquad (10)$$

Substituting $K = n\lambda/p$, for diffraction order $n$ and target pitch $p$, the following can be defined: $R'(K, h) = R(pK/n,h)$ and with some calculus:

$$\frac{\partial R'}{\partial h} = -\frac{K}{h} \frac{\partial R'}{\partial K} \qquad (11)$$

In pupil space, with $\kappa = \kappa_0 + K$, it can be written that $\hat{R}(\kappa, h) = R'(\kappa - \kappa_0, h)$ and the derivative with respect to layer thickness becomes:

$$\frac{\partial \hat{R}}{\partial h} = -\frac{\kappa - \kappa_0}{h} \frac{\partial \hat{R}}{\partial \kappa} \qquad (12)$$

The factor $1/h$ above can be interpreted as referring to the layer thickness of the topmost layer, or as a combined effect of multiple layers, i.e., $1/h = a_1/h_1 + a_2/h_2 + \cdots$ with appropriate coefficients a1, a2, .... If the second layer from the top is thick (e.g. > 50 nm), then the lower layers may have much less influence on the diffraction pattern, due to absorption losses.

It should be noted that Equation (12) is expressed in terms of reflectance ($R$), while the equivalent equation (7) for $\theta$ is expressed in terms of detector signals ($I$). The choice is entirely arbitrary. Equation (12) could be reworked in terms of detector signals, or the detector signals may be converted to reflectances before applying the corrections.

The expression for $\partial\hat{R}/\partial h$ may be used to remove any contribution to the signal caused by layer thickness variations, along the same lines as steps 1020 and 1030, described above. In this case, the value of $h$ does not need to be known at all. Further analysis may optionally be performed to estimate the actual deviation of $h$ from its nominal value.

As already mentioned, the method of Figure 10 may be applied to other drift parameters; in each case the step of determining the partial derivative is more straightforward.

With respect to the dependence on azimuth angle $\varphi$, typically, the plane of incidence is chosen to be a symmetry plane of the target. Due to this symmetry, the target response has zero derivative to the $\varphi$ angle. Even if the target is slightly asymmetric (e.g., due to a small overlay error), the target-response derivative will be very small. Therefore, assuming the target reflection coefficient remains unchanged, a change in azimuth angle $\varphi$ will manifest itself as an angle $\varphi$ dependent shift on the detector. The partial derivative in pupil space may be:

$$\frac{\partial \hat{I}(\kappa)}{\partial \varphi} = \nabla \hat{I}(\kappa) \cdot \begin{pmatrix} \sin\theta \sin\varphi \\ -\sin\theta \cos\varphi \end{pmatrix} \qquad (13).$$

This derivative can be converted to detector space if necessary.

The partial derivatives to detector position and orientation (e.g., to correct for changes of a position of the sensor by calculating how a moved sensor influences the image) are also relatively straightforward. They can be estimated from a single detector image (single value of $i$) and may therefore have different values for different images. They can also be estimated from the reference image ($I_0[j,k]$).

The partial derivatives may be determined separately for detector x position and detector y position; for example:

$$\frac{\partial I[j,k]}{\partial x} = \frac{(I[j,k+1] - I[j,k-1])}{2\,\delta x} \qquad (14a)$$

$$\frac{\partial I[j,k]}{\partial y} = \frac{(I[j+1,k] - I[j-1,k])}{2\,\delta y} \qquad (14b)$$

where $\delta x$ and $\delta y$ is the pixel size in the respective dimensions.

The other detector derivatives may be estimated by mapping the signal to $I'(\kappa)$ in pupil space, assuming the best estimate of the tool-parameter values (for example, the nominal values), then transforming back to detector space with one parameter perturbed by a small amount $\delta p$, resulting in a perturbed signal $I''[j,k]$. The corresponding derivative will then be ($I''[j,k]$ - $I[j,k]$)/$\delta p$. Optionally, a smoothing filter may be applied on the data in detector space if the signal is noisy.

Other drift parameters may include one or more parameters of the illumination supply. For example, the signal derivative with respect to illumination (e.g., SXR) power may be useful and can be estimated from only the measured signal; it is equal to the signal $I[i,j,k]$ divided by the nominal source power in arbitrary units (one arbitrary unit may be taken equal to the nominal source power).

The signal derivative with respect to illumination (e.g., SXR) beam divergence can be estimated by convolving the signal in pupil space with a convolution kernel and subtracting the original signal from it. For example, if the nominal SXR beam has a Gaussian profile with divergence $D$ (in pupil space), then the effect of a divergence change $\Delta D$ is equivalent to a convolution in pupil space with a Gaussian convolution kernel G that has divergence $\sqrt{2D\,\Delta D}$. The derivative can then be estimated as:

$$\frac{\partial \hat{I}}{\partial D} = \frac{\hat{I} * G - \hat{I}}{\Delta D}.$$

This is not a true derivative; it relies on the value of $\Delta D$ being chosen realistically, or multiple derivatives for multiple $\Delta D$ values could be taken.

In the above description, there is an assumption that the tool has been pre-aligned to an accuracy such that the position of wavelength components on the detector deviates from the expected position by significantly less than the spot size on the detector. With a typical beam divergence D=2 mrad and typical target-detector distance L=20 mm, this would mean position errors much less than 40 $\mu$m (=L*D) and angle errors much less than 2 mrad (=D).

In the above description, an example value for nominal angle or incidence $\theta$ is described as 30 degrees. This is purely exemplary and any practical angle of incidence may be used' e.g., between 10 and 90 degrees or between 20 and 90 degrees. For example, methods using SXR radiation may use an angle of incidence between 10 and 70 degrees or between 20 and 50 degrees or 20 and 40 degrees. Method using hard x-ray wavelengths, may use an angle of incidence between 85 and 90 degrees, for example.

Further embodiments are disclosed in the subsequent numbered clauses:

1. A method of metrology comprising:

obtaining measurement data relating to at least one measurement of each of one or more structures on a substrate; the measurement data being dependent upon one or more drift parameters, said drift parameters comprising at least one interdependent drift parameter for which each measurement is dependent on a structure response metric which varies with an illumination setting and said at least one interdependent drift parameter interdependently; and
correcting the measurement data based on an approximately invariant transformation of said structure response metric or related metric.

2. A method as claimed in clause 1, wherein the illumination setting comprises one or more wavelengths of measurement illumination used to obtain said measurement data.

3. A method as claimed in clause 2, wherein measurement illumination comprises one or more wavelengths in the range of 0.01 nm to 20 nm.

4. A method as claimed in clause 2 or 3, wherein the at least one interdependent drift parameter comprises an angle of incidence of the measurement illumination on said structure.

5. A method as claimed in clause 4, wherein the angle of incidence has a nominal value between 20 and 90 degrees.

6. A method as claimed in any preceding clause, wherein the at least one interdependent drift parameter comprises a total thickness of one or more layers on said substrate.

7. A method as claimed in any preceding clause, wherein the approximately invariant transformation of said structure response metric describes a set of pairs of the at least one interdependent drift parameter and said illumination setting which each having an approximately common value for the structure response metric.

8. A method as claimed in any preceding clause, wherein the transformation comprises transforming a first value of the interdependent parameter to a second value of the interdependent parameter and scaling a first value of the illumination setting to obtain a second value for the illumination setting; the scaling comprising a ratio of the second value of the interdependent parameter or a trigonometric function thereof and the first value of the interdependent parameter or a trigonometric function thereof.

9. A method as claimed in any preceding clause, wherein the structure comprises a grating structure and the structure response metric comprises a diffraction efficiency metric for the structure.

10. A method as claimed in any preceding clause, wherein said step of correcting the measurement data comprises:

determining one or more partial derivatives for said measurement data, each partial derivative describing a variation in the measurements in terms of each of said one or more drift parameters, wherein the determining of the partial derivative for said at least one interdependent drift parameter comprises determining the partial derivative of the approximately invariant transformation of said structure response metric or related metric; and correcting the measurement data based on the one or more partial derivatives to obtain said corrected measurement data.

11. A method as claimed in clause 10, comprising the initial step of determining difference data describing differences in each of said measurements with respect to a reference measurement value; said measurement data comprising said difference data and said reference measurement value.

12. A method as claimed in clause 11, wherein the reference measurement value comprises an average of said measurements.

13. A method as claimed in clause 11 or 12, comprising determining corrected measurement data by performing a minimization of the difference data and said partial derivatives in terms of coefficients therefor, the corrected measurement data having had a component subtracted which the minimization estimates to be related to drift in said one or more drift parameters.

14. A method as claimed in any of clauses 10 to 13, wherein said measurements each comprise an image captured by a detector at a detector plane.

15. A method as claimed in clause 14, wherein said method comprises mapping the measurement data from an image plane representation to a pupil plane representation.

16. A method as claimed in clause 14 or 15, wherein the drift parameters further comprise one or more parameters relating to the detector position.

17. A method as claimed in clause 16, wherein determining a partial derivative for one or more parameters relating to the detector position comprising performing for each of a first direction and second direction of the image plane, the step of:

determining for each pixel of each image, a difference between a measured value for adjacent pixels on either side of that pixel in the respective direction divided by twice the pixel size in that direction.

18. A method as claimed in clause 16 or 17, wherein determining a partial derivative for one or more parameters relating to detector position comprises:

mapping the measurement data from an original image plane representation to a pupil plane representation; imposing a perturbation to the pupil plane representation; transforming back the perturbed pupil plane representation to a perturbed image plane representation; and determining the partial derivative as a difference between perturbed image plane representation and original image plane representation divided by the perturbation.

19. A method as claimed in any of clauses 10 to 18, wherein the drift parameters further comprise an azimuth angle.

20. A method as claimed in any of clauses 10 to 19, wherein the drift parameters further comprise one or both of the illumination power and illumination beam divergence.

21. A method as claimed in clause 20, wherein a partial derivative of illumination beam divergence is estimated by convolving each measurement in pupil space with a convolution kernel and subtracting the original measurement from the convolution.

22. A method as claimed in clause or 21, wherein a partial derivative of illumination power is estimated by dividing the measurements by the nominal source power.

23. A method as claimed in any preceding clause, wherein said one or more structures comprise a plurality of similar structures.

24. A method as claimed in any preceding clause, wherein the drift parameters further comprise the azimuth angle.

25. A method as claimed in any preceding clause, comprising performing said measurements to obtain said measurement data.

26. A computer program comprising computer readable instruction operable to perform at least the processing and determining a position steps of the method of any of clauses 1 to 24.

27. A processor and associated storage medium, said storage medium comprising the computer program of clause 26 such that said processor is operable to perform the method of any of clauses 1 to 24.

28. A metrology device comprising the processor and associated storage medium of clause 27 so as to be operable to perform the method of any of clauses 1 to 25.

29. The metrology device of clause 28, operable to determine a parameter of interest from the corrected measurement data.

30. The metrology device of clause 29, wherein the parameter of interest comprises on or more of overlay, critical dimension, focus, edge placement error on a substrate having been subject to a lithographic process.

31. The metrology device of clause 29, wherein the parameter of interest comprises a position of the structure.

32. A lithographic apparatus arrangement comprising the metrology device of any of clauses 28 to 31.

33. A lithographic cell operable to perform the method of any of clauses 1 to 25.

34. A metrology device operable to perform the method of any of clauses 1 to 25.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays. As an alternative to optical metrology methods, it has also been considered to use X-rays, optionally hard X-rays, for example radiation in a wavelength range between 0.01nm and 10nm, or optionally between 0.01nm and 0.2 nm, or optionally between 0.1nm and 0.2nm, for metrology measurements. As such any of the aforementioned references to SXR radiation should be explicitly understood to optionally encompass radiation with wavelengths (e.g., substantial energy) between 0.01nm and 0.2 nm as an alternative to only SXR (and/or EUV) wavelengths according to other definitions herein.

**Claims**

1. A method of metrology comprising:

   obtaining measurement data relating to at least one measurement of each of one or more structures on a substrate; the measurement data being dependent upon one or more drift parameters, said drift parameters comprising at least one interdependent drift parameter for which each measurement is dependent on a structure response metric which varies with an illumination setting and said at least one interdependent drift parameter interdependently; and
   correcting the measurement data based on an approximately invariant transformation of said structure response metric or related metric.

2. A method as claimed in claim 1, wherein measurement illumination comprises one or more wavelengths in the range of 0.01 nm to 20 nm.

3. A method as claimed in claim 2, wherein the at least one interdependent drift parameter comprises an angle of incidence of the measurement illumination on said structure, optionally, the angle of incidence has a nominal value between 20 and 90 degrees.

4. A method as claimed in any preceding claim, wherein the at least one interdependent drift parameter comprises a total thickness of one or more layers on said substrate.

5. A method as claimed in any preceding claim, wherein the approximately invariant transformation of said structure response metric describes a set of pairs of the at least one interdependent drift parameter and said illumination setting which each having an approximately common value for the structure response metric.

6. A method as claimed in any preceding claim, wherein the transformation comprises transforming a first value of the interdependent parameter to a second value of the interdependent parameter and scaling a first value of the illumination setting to obtain a second value for the illumination setting; the scaling comprising a ratio of the second value of the interdependent parameter or a trigonometric function thereof and the first value of the interdependent parameter or a trigonometric function thereof.

7. A method as claimed in any preceding claim, wherein the structure comprises a grating structure and the structure response metric comprises a diffraction efficiency metric for the structure.

8. A method as claimed in any preceding claim, wherein said step of correcting the measurement data comprises:

   determining one or more partial derivatives for said measurement data, each partial derivative describing a variation in the measurements in terms of each of said one or more drift parameters, wherein the determining of the partial derivative for said at least one interdependent drift parameter comprises determining the partial derivative of the approximately invariant transformation of said structure response metric or related metric; and correcting the measurement data based on the one or more partial derivatives to obtain said corrected measurement data.

9. A method as claimed in claim 8, comprising the initial step of determining difference data describing differences in each of said measurements with respect to a reference measurement value; said measurement data comprising said difference data and said reference measurement value, optionally, the reference measurement value comprises an average of said measurements.

10. A method as claimed in claim 9, comprising determining corrected measurement data by performing a minimization of the difference data and said partial derivatives in terms of coefficients therefor, the corrected measurement data having had a component subtracted which the minimization estimates to be related to drift in said one or more drift parameters.

11. A method as claimed in any of claims 8 to 10, wherein said measurements each comprise an image captured by a detector at a detector plane, wherein said method comprises mapping the measurement data from an image plane representation to a pupil plane representation, wherein the drift parameters further comprise one or more parameters relating to the detector position, wherein determining a partial derivative for one or more parameters relating to the detector position comprising performing for each of a first direction and second direction of the image plane, the step of:
determining for each pixel of each image, a difference between a measured value for adjacent pixels on either side of that pixel in the respective direction divided by twice the pixel size in that direction.

12. A method as claimed in claim 11, wherein determining a partial derivative for one or more parameters relating to detector position comprises:

mapping the measurement data from an original image plane representation to a pupil plane representation; imposing a perturbation to the pupil plane representation; transforming back the perturbed pupil plane representation to a perturbed image plane representation; and determining the partial derivative as a difference between perturbed image plane representation and original image plane representation divided by the perturbation.

13. A method as claimed in any of claims 8 to 12, wherein the drift parameters further comprise one or both of the illumination power and illumination beam divergence.

14. A metrology device operable to perform the method of any of claims 1 to 13.

15. A lithographic cell operable to perform the method of any of claims 1 to 13.

Fig. 1

Fig. 2

LA

SC1

SC3

CL

0

-1        +1

MT

SC2

Fig. 3

2

4

SM1

Z

X

PU

W

I

6

λ

Z

8

X

Fig. 4

Fig. 5

Fig. 6

Fig. 7

Fig. 8

Fig. 9

Fig. 10

Fig.11

(a)

(b)

Fig.12

Europäisches
Patentamt

European
Patent Office

Office européen
des brevets

# EUROPEAN SEARCH REPORT

Application Number

EP 20 15 1585

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/056673 A1 (LI FAHONG [NL] ET AL) 21 February 2019 (2019-02-21) * paragraph [0001] * * paragraphs [0107] - [0125]; figures 3-5 * * paragraphs [0143] - [0158]; figures 8-10 * * paragraphs [0350] - [0355] * ----- | 1-15 | INV. G03F7/20 |
| A | WO 2019/121486 A1 (ASML NETHERLANDS BV [NL]) 27 June 2019 (2019-06-27) * paragraph [0002] * * paragraphs [0034] - [0044]; figures 4-6 * * paragraphs [0221] - [0237] * * paragraph [292;308] * ----- | 1-15 | |
| A | US 2013/114081 A1 (FUKAZAWA KAZUHIKO [JP]) 9 May 2013 (2013-05-09) * paragraphs [0024] - [0039]; figures 1,2,13 * * paragraphs [0069] - [0084]; figure 14 * ----- | 1-15 | TECHNICAL FIELDS SEARCHED (IPC)  G03F |

The present search report has been drawn up for all claims

| Place of search | Date of completion of the search | Examiner |
|---|---|---|
| Munich | 6 July 2020 | van Toledo, Wiebo |

EPO FORM 1503 03.82 (P04C01)

# EP 3 851 915 A1

## ANNEX TO THE EUROPEAN SEARCH REPORT
## ON EUROPEAN PATENT APPLICATION NO.

EP 20 15 1585

This annex lists the patent family members relating to the patent documents cited in the above-mentioned European search report.
The members are as contained in the European Patent Office EDP file on
The European Patent Office is in no way liable for these particulars which are merely given for the purpose of information.

06-07-2020

| Patent document cited in search report | | Publication date | Patent family member(s) | | Publication date |
|---|---|---|---|---|---|
| US 2019056673 | A1 | 21-02-2019 | EP | 3447580 A1 | 27-02-2019 |
| | | | TW | 201921138 A | 01-06-2019 |
| | | | US | 2019056673 A1 | 21-02-2019 |
| | | | WO | 2019037953 A1 | 28-02-2019 |
| WO 2019121486 | A1 | 27-06-2019 | TW | 201937305 A | 16-09-2019 |
| | | | WO | 2019121486 A1 | 27-06-2019 |
| US 2013114081 | A1 | 09-05-2013 | CN | 102884609 A | 16-01-2013 |
| | | | JP | 5790644 B2 | 07-10-2015 |
| | | | JP | WO2011135867 A1 | 18-07-2013 |
| | | | KR | 20130073886 A | 03-07-2013 |
| | | | US | 2013114081 A1 | 09-05-2013 |
| | | | WO | 2011135867 A1 | 03-11-2011 |

EPO FORM P0459

For more details about this annex : see Official Journal of the European Patent Office, No. 12/82

31

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2007224518 A
- US 20130304424 A1
- US 2014019097 A1, Bakeman
- US 20170184981 A1
- US 2016282282 A1
- CN 101515105 B
- WO 2017186483 A1
- US 7265364 B
- US 7646471 B
- US 2010233600 A1
- WO 2016102127 A1
- US 6961116 B
- US 2015261097 A1

### Non-patent literature cited in the description

- **LEMAILLET et al.** Intercomparison between optical and X-ray scatterometry measurements of FinFET structures. *Proc. of SPIE,* 2013, 8681